# EUROPEAN PATENT SPECIFICATION

(11) **EP 4 116 763 B1**
(45) Date of publication and mention of the grant of the patent: **03.12.2025**
(21) Application number: 22174792.6
(22) Date of filing: 23.05.2022
(51) Int. Cl.: G02F 1/1333

(54) **DISPLAY DEVICE**
ANZEIGEVORRICHTUNG
DISPOSITIF D'AFFICHAGE

(30) Priority: 07.07.2021 KR 20210088886
(43) Date of publication of application: 11.01.2023
(73) Proprietor: LG Display Co., Ltd., SEOUL, 07336 (KR)
(72) Inventor: SUNG, Chikyung, 10845 Paju-si, Gyeonggi-do (KR); PARK, Chanhyeok, 10845 Paju-si, Gyeonggi-do (KR)
(74) Representative: Viering, Jentschura & Partner mbB Patent- und Rechtsanwälte

(56) References cited:
- US-A1- 2005 068 738
- US-A1- 2020 194 710

## Description

### BACKGROUND

### Field

The present disclosure relates to a display device, and more particularly, to a display device capable of increasing rigidity and preventing moisture permeation.

### Description of Related Art

A display device that displays an image on a TV, a monitor, a smart phone, a tablet PC, a laptop computer, and the like is used in various manners and forms.

Following a liquid crystal display device (LCD) that has been used up to now among the display devices, use and range of applications of an organic light-emitting display device (OLED) are gradually expanding.

The display device includes a liquid crystal or a light-emitting element to realize the image, and includes a thin-film transistor for individually controlling an operation of each liquid crystal or light-emitting element, to display the image to be displayed on a substrate.

Among the display devices, the organic light-emitting display device includes a thin-film transistor for driving a pixel and a light-emitting element that generates light by receiving a signal from the thin-film transistor.

The light-emitting element includes a light-emitting layer, an anode electrode for applying a voltage to the light-emitting layer, and a cathode electrode for applying a common electrode. The light-emitting layer may be disposed between the anode electrode and the cathode electrode, so that holes injected from the anode electrode move to the light-emitting layer and electrons injected from the cathode electrode move to the light-emitting layer, and the electrons and the holes are recombined with each other in the light-emitting layer to generate excitons. As a state of the exciton changes from an excited state to a ground state, fluorescent molecules of the light-emitting layer emit light to display the image.

The display device includes a display area to form the image and a non-display area in which various additional components such as a circuit board or a driving integrated circuit are disposed.

The additional components may be located in the non-display area. A thickness and a width of the display device may increase due to the additional components.

The increase in the thickness and the width of the display device is disadvantageous in terms of portability or design. Therefore, various technologies for reducing the thickness and the width of the display device have been developed.

Further, the display device may be easily damaged by an external impact or external moisture may penetrate into the display device due to a small thickness and a complex configuration of the display device, so that a structure to improve rigidity and a waterproof function is also being developed.

US 2020 / 0 194 710 A1 describes a display panel that adopts an emerging porous metal material, and utilizes characteristics of the material as a composite functional layer of the panel, so that it can simultaneously assume functions of protection, cushioning, and heat dissipation, and achieve a purpose of simplifying a structure of a display device and reducing the thickness of components. US 2005/068738 A1 discloses a display device comprising a metallic cushion layer for protection purposes.

### SUMMARY

A display device according to claim 1 is provided. Further embodiments are described in the dependent claims.

Components such as a light-emitting element and a thin-film transistor constituting a display device are vulnerable to an impact or moisture.

When a thickness of the component is reduced or the component is changed to reduce a thickness and a width of the display device, an impact-absorption function and a waterproof function may be reduced.

The present disclosure aims to improve the impact-absorption function and the waterproof function while reducing the thickness and the width of the display device.

Purposes of the present disclosure are not limited to the above-mentioned purpose. Other purposes and advantages of the present disclosure that are not mentioned may be understood based on following descriptions, and may be more clearly understood based on embodiments of the present disclosure. Further, it will be easily understood that the purposes and advantages of the present disclosure may be realized using means shown in the claims and combinations thereof.

A display device according to an embodiment of the present disclosure may include a display panel for displaying an image, a support member disposed under the display panel, and a cushion plate disposed under the support member and including a porous substrate. Corresponding side surfaces of the display panel, the support member, and the cushion plate may be aligned with each other or may coincide with each other. Moreover, a resin may be disposed on side surfaces of the display panel, the support member, and the cushion plate.

In another embodiment, a display device comprises a display panel for displaying an image, a cushion plate disposed under the display panel and including a porous substrate, and a resin disposed on one or more surfaces of the display panel and the cushion plate. The corresponding side surfaces of the display panel and the cushion plate are aligned with each other, and the resin is disposed on the corresponding side surfaces of the display panel and the cushion plate.

Specific details of other embodiments are included in the detailed description and the drawings.

According to an embodiment of the present disclosure, the impact-absorption function may be improved while reducing the thickness of the display device by constituting the cushion plate placed below the display panel with the porous substrate.

Further, the damage of the display panel caused by the external impact may be reduced and the moisture permeation may be prevented by making the corresponding distal ends of the display panel, the support member, and the cushion plate to coincide with each other or to be aligned with each other such that there are no protruding components.

Further, the rigidity and the waterproof performance may be further improved by applying the resin to the side surface of the display device where the corresponding distal ends of the display panel, the support member, and the cushion plate coincide with each other.

Effects of the present disclosure are not limited to the above-mentioned effects, and other effects as not mentioned will be clearly understood by those skilled in the art from following descriptions.

### BRIEF DESCRIPTION OF DRAWINGS

FIG. 1A is a plan view according to an embodiment of the present disclosure.
FIG. 1B is a cross-sectional view taken along a line I-I' in FIG. 1A.
FIG. 2A is a plan view according to another embodiment of the present disclosure.
FIG. 2B is a cross-sectional view taken along a line II-II' in FIG. 2A.
FIG. 3A is a cross-sectional view showing a display device in FIG. 2B.
FIG. 3B is a product application picture of FIG. 3A.
FIG. 4 is a cross-sectional view of an adhesive member according to an embodiment of the present disclosure.
FIG. 5 is a cross-sectional view showing an embodiment of the present disclosure in which a resin is applied onto a display device.
FIG. 6 is a cross-sectional view showing another embodiment of the present disclosure in which a resin is applied onto a display device.

### DETAILED DESCRIPTIONS

Advantages and features of the present disclosure, and a method of achieving the Advantages and features will become apparent with reference to embodiments described later in detail together with the accompanying drawings. However, the present disclosure is not limited to the embodiments as disclosed below, but may be implemented in various different forms. Thus, these embodiments are set forth only to make the present disclosure complete, and to completely inform the scope of the disclosure to those of ordinary skill in the technical field to which the present disclosure belongs, and the present disclosure is only defined by the scope of the claims.

A shape, a size, a ratio, an angle, a number, etc. disclosed in the drawings for describing the embodiments of the present disclosure are exemplary, and the present disclosure is not limited thereto. The same reference numerals refer to the same elements herein. Further, descriptions and details of well-known steps and elements are omitted for simplicity of the description. Furthermore, in the following detailed description of the present disclosure, numerous specific details are set forth in order to provide a thorough understanding of the present disclosure. However, it will be understood that the present disclosure may be practiced without these specific details. In other instances, well-known methods, procedures, components, and circuits have not been described in detail so as not to unnecessarily obscure aspects of the present disclosure.

The terminology used herein is directed to the purpose of describing particular embodiments only and is not intended to be limiting of the present disclosure. As used herein, the singular constitutes "a" and "an" are intended to include the plural constitutes as well, unless the context clearly indicates otherwise. It will be further understood that the terms "comprise", "comprising", "include", and "including" when used in this specification, specify the presence of the stated features, integers, operations, elements, and/or components, but do not preclude the presence or addition of one or more other features, integers, operations, elements, components, and/or portions thereof. As used herein, the term "and/or" includes any and all combinations of one or more of the associated listed items. Expression such as "at least one of" when preceding a list of elements may modify the entire list of elements and may not modify the individual elements of the list. In interpretation of numerical values, an error or tolerance therein may occur even when there is no explicit description thereof.

In addition, it will also be understood that when a first element or layer is referred to as being present "on" a second element or layer, the first element may be disposed directly on the second element or may be disposed indirectly on the second element with a third element or layer being disposed between the first and second elements or layers. It will be understood that when an element or layer is referred to as being "connected to", or "coupled to" another element or layer, it may be directly on, connected to, or coupled to the other element or layer, or one or more intervening elements or layers may be present. In addition, it will also be understood that when an element or layer is referred to as being "between" two elements or layers, it may be the only element or layer between the two elements or layers, or one or more intervening elements or layers may also be present.

Further, as used herein, when a layer, film, region, plate, or the like is disposed "on" or "on a top" of another layer, film, region, plate, or the like, the former may directly contact the latter or still another layer, film, region, plate, or the like may be disposed between the former and the latter. As used herein, when a layer, film, region, plate, or the like is directly disposed "on" or "on a top" of another layer, film, region, plate, or the like, the former directly contacts the latter and still another layer, film, region, plate, or the like is not disposed between the former and the latter. Further, as used herein, when a layer, film, region, plate, or the like is disposed "below" or "under" another layer, film, region, plate, or the like, the former may directly contact the latter or still another layer, film, region, plate, or the like may be disposed between the former and the latter. As used herein, when a layer, film, region, plate, or the like is directly disposed "below" or "under" another layer, film, region, plate, or the like, the former directly contacts the latter and still another layer, film, region, plate, or the like is not disposed between the former and the latter.

In descriptions of temporal relationships, for example, temporal precedent relationships between two events such as "after", "subsequent to", "before", etc., another event may occur therebetween unless "directly after", "directly subsequent" or "directly before" is not indicated.

It will be understood that, although the terms "first", "second", "third", and so on may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present disclosure.

The features of the various embodiments of the present disclosure may be partially or entirely combined with each other, and may be technically associated with each other or operate with each other. The embodiments may be implemented independently of each other and may be implemented together in an association relationship.

As used herein, the term "substantially," "about," and similar terms are used as terms of approximation, and are intended to account for inherent deviations in measured or calculated values that would be recognized by those of ordinary skill in the art. The term may be used to prevent unauthorized exploitation by an unauthorized infringer to design around accurate or absolute figures provided to help understand the present disclosure.

Unless otherwise defined, all terms including technical and scientific terms used herein have the same meaning as commonly understood by one of ordinary skill in the art to which this inventive concept belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

A display device of the present disclosure may be applied to an organic light-emitting display device, but may not be limited thereto, and may be applied to various display devices such as an LED display device or a quantum dot display device.

Hereinafter, with reference to the drawings, the present disclosure will be described.

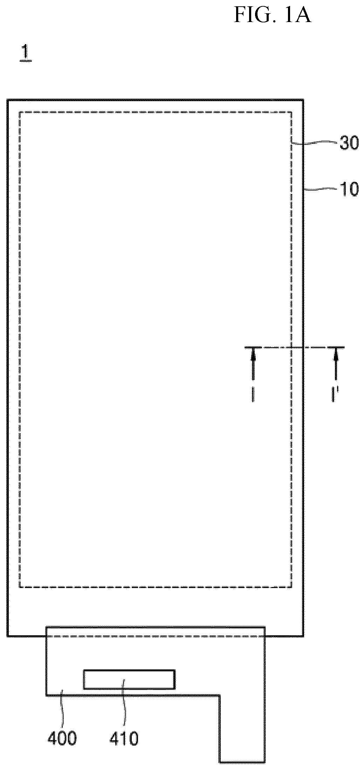

FIG. 1A is a plan view according to an example not according to the invention.

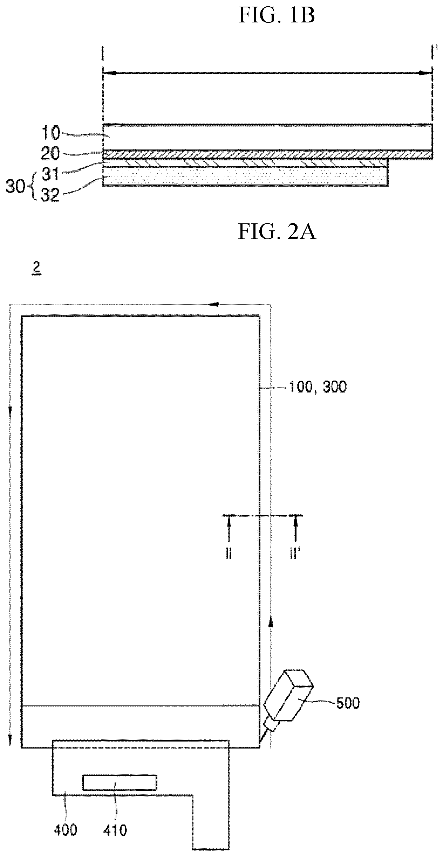

FIG. 1B is a cross-sectional view taken along a line I-I' in FIG. 1A.

Referring to FIGs. 1A and 1B, a display device 1 may include various components such as a display panel 10, a support member 20, and a cushion plate 30.

The display panel 10 may include a substrate made of a polymer, a plastic such as polyimide (PI), or a glass. The substrate may include a display area for displaying an image and a non-display area. A plurality of sub-pixels for displaying the image and a driving circuit for driving the plurality of sub-pixels may be disposed in the display area. A pixel array may include the plurality of sub-pixels and the driving circuit.

The non-display area, which is an area surrounding the display area, may be an area in which the image is not displayed.

A bezel may be the non-display area surrounding the display area in a product to which the display device 1 is applied. The non-display area and the bezel of the display device 1 may be the same area.

A circuit board 400 or a driving integrated circuit 410 may be disposed in the non-display area.

As an embodiment of the present disclosure, the driving integrated circuit 410 may be applied as a chip on plastic (COP) that is directly mounted on the display panel 10. As shown in FIG. 1A, it is also possible to apply the driving integrated circuit 410 as a chip on film (COF) mounted on the circuit board 400, but the present disclosure is not limited thereto.

The circuit board 400 may be a flexible printed circuit board (FPCB), and the circuit board 400 may be applied as a film on plastic (FOP) directly mounted on or attached to the display panel 10.

The circuit board 400 may be bent such that a distal end on one side thereof is attached to the non-display area of the display panel 10 and a distal end on the other side thereof is disposed on a back surface of the display panel 10 to reduce the non-display area of the display panel 10 that is visually recognized from the front. Further, a distal end of the display panel 10 on which the circuit board 400 is mounted may also be bent to a certain level together with the circuit board 400, thereby further reducing the non-display area of the display panel 10 that is visually recognized from the front.

In order to reduce the non-display area of the display panel 10 visually recognized from the front as much as possible, the distal end on one side end of the display panel 10 may be bent and placed on the back surface of the display panel 10.

Based on the bent state of the circuit board 400, the driving integrated circuit 410 may be disposed on a back surface of a display substrate.

As a radius of curvature at which the display panel 10 or the circuit board 400 is bent increases, the non-display area of the display panel 10 visually recognized from the front increases. An overall thickness of the display device 1 may be reduced to reduce the radius of curvature of the circuit board 400.

A thin-film transistor layer may be disposed on the substrate of the display panel 10. The thin-film transistor layer may include a plurality of insulating layer, a planarization film, a driving thin-film transistor, and the like. The driving thin-film transistor may include a gate electrode, an active layer, a source electrode, and a drain electrode.

A light-emitting element may be disposed on the thin-film transistor layer. The light-emitting element may include a first electrode, a light-emitting layer, and a second electrode. The light-emitting element may correspond to the display area of the substrate. The light-emitting element may emit light by means of a high-potential data voltage supplied to the second electrode via the driving thin-film transistor and a low-potential common voltage supplied to the first electrode. The light generated from the light-emitting element may be emitted in a forward direction to realize a desired image.

An encapsulation unit may be disposed on the light-emitting element. The encapsulation unit may protect the thin-film transistor layer and the light-emitting element from an external impact, and prevent penetration of oxygen or moisture into the thin-film transistor layer and the light-emitting element. The encapsulation unit may include at least one inorganic film and organic film, but may not be limited thereto.

An optical film may be additionally disposed on the encapsulation unit. The optical film may have a form in which one or more functional layers are stacked, but may not be limited thereto.

For example, the optical film may include an anti-reflection layer such as a polarizing film that may improve outdoor visibility and contrast of the image displayed on the display panel 10 by preventing reflection of external light.

As another example, the optical film may further include a barrier layer for preventing the penetration of the moisture or the oxygen. The barrier layer may be made of a material having low moisture permeability, such as a polymer material.

The pixel array may include the thin-film transistor layer and the light-emitting element. The pixel array includes the plurality of sub-pixels. Each of the plurality of sub-pixels may be an individual unit emitting light, and the light-emitting element may be disposed in each of the plurality of sub-pixels. The plurality of sub-pixels may include, but may not be limited to, a red sub-pixel, a green sub-pixel, and a blue sub-pixel. As another example, the plurality of sub-pixels may include, but may not be limited to, the red sub-pixel, the green sub-pixel, the blue sub-pixel, and a white sub-pixel.

In order to drive the plurality of sub-pixels, the driving circuit including various thin-film transistors and storage capacitors, and a signal wire may be included. For example, the driving circuit may include various components such as the driving thin-film transistor, a switching thin-film transistor, a storage capacitor, and the like. Moreover, the signal wire may include a gate wire and a data wire, but may not be limited thereto.

The driving integrated circuit 410 generates a data signal and a gate control signal based on a timing synchronization signal and image data supplied from an external host driving system. Moreover, the driving circuit may supply the data signal to the data wire of each pixel via a display pad, and may supply the gate control signal to the gate driving circuit.

Because the driving integrated circuit 410 generates high-temperature heat, it may be necessary to effectively impart a heat-dissipation effect to the driving integrated circuit 410. For example, the driving integrated circuit 410 may effectively dissipate the heat by the cushion plate 30.

Because the cushion plate 30 is located between the display panel 10 and the driving integrated circuit 410, it is possible to effectively dissipate the heat generated from the display panel 10 as well as the driving integrated circuit 410.

A cover member may be disposed on a front surface of the display panel 10. The cover member may be disposed to cover the front surface of the display panel 10 to protect the display panel 10 from the external impact.

The display panel 10 displays the image through a front surface of the cover member. Because the cover member overlaps the display area for displaying the image, the cover member may be made of a transparent material such as a cover glass to display the image. For example, the cover member may be made of a transparent plastic material, a glass material, or a reinforced glass material.

The support member 20 is disposed under the display panel 10.

The support member 20 is disposed under the display substrate to supplement rigidity of the display substrate. The support member 20 may be formed to have certain strength and thickness to supplement the rigidity of the display substrate.

The support member 20 may be made of polyethyleneterephthalate (PET), polycarbonate (PC), polyimide (PI), and the like.

The cushion plate 30 is disposed under the support member 20.

The cushion plate 30 may have the heat-dissipation function and an impact-absorption function, and may include an adhesive member 31 and a porous substrate 32. For example, the adhesive member 31 and the porous substrate 32 may be sequentially stacked in a direction of the back surface of the display panel 10.

As another embodiment of the present disclosure, the cushion plate 30 may be formed as a plurality of layers having various functions such as a heat-dissipation layer with the heat-dissipation function, a cushion layer capable of absorbing the impact, an adhesive layer that bonds the heat-dissipation layer and the cushion layer to each other, and the like are stacked.

In the structure including the heat-dissipation layer and the cushion layer, thicknesses of the heat-dissipation layer and the cushion layer may be great to increase the heat-dissipation function and the impact-absorption function. However, as the thicknesses of the heat-dissipation layer and the cushion layer increase, the overall thickness of the display device increases, and thus, a radius of curvature of a bendable area of the display panel 10 also increases due to the increase in the thickness, thereby increasing the non-display area.

In order to reduce the thickness while having the functions of the heat-dissipation layer and the cushion layer, the porous substrate 32 shown in FIG. 1B may be applied.

The porous substrate 32 has a single structure of a conductive metal rather than a stack structure of the heat-dissipation layer and the cushion layer, so that separation of layers does not occur and the porous substrate 32 is able to have both the heat-dissipation function and the impact absorption function. Detailed features of the porous substrate 32 will be described later.

The cushion plate 30 to which the porous substrate 32 is applied may further include the adhesive member 31 for adhesion with the support member 20.

The cushion plate 30 may be formed to be smaller than the display panel 10 and the support member 20, and may be attached to a back surface of the support member 20 via the adhesive member 31.

The porous substrate 32 may be formed to be larger than the display panel 10 and the support member 20. When the porous substrate 32 is formed to be larger than the display panel 10, the non-display area may be increased.

In order not to increase the non-display area, the porous substrate 32 may be formed to overlap the display panel 10 as a whole within an area that does not go beyond distal ends of the display panel 10 and the support member 20, or may be formed to be smaller than the support member 20 within the bendable area in which the display panel 10 and the circuit board 400 are bendable.

When the cushion plate 30 is formed to be smaller than the support member 20, a weight thereof may be reduced and a manufacturing cost thereof may be reduced, but the heat-dissipation function and the impact-absorption function may be degraded.

Moreover, a step may be formed between the cushion plate 30 and the support member 20.

Referring to FIG. 1B, in the cross-sectional view of the display device 1, the step is a portion formed in a step shape as the display panel 10 and the support member 20 protrude more than the cushion plate 30.

At the distal end of the display panel 10 where the step is formed, the display panel 10 protrudes without being supported by the cushion plate 30, so that the display panel 10 may be easily damaged when the external impact is applied.

Further, moisture may be easily concentrated at the step because a speed at which the moisture is volatilized is lower than that on a flat portion, and an adhesive force of the adhesive member 31 disposed at the step may also be weakened by the external impact, so that external moisture and foreign substances may be easily introduced.

When external moisture flows into the display panel 10, the light-emitting layer of the light-emitting element made of an organic material may be damaged and the light may not be generated. A dark spot may occur on the display panel 10 due to the damage to the light-emitting layer, and the dark spot may become larger and larger as time goes by, making it impossible to realize the desired image. Accordingly, several experiments were performed to remove the step of the display device 1. Through the several experiments, a new display device that may remove the step of the display device 1 and prevent the damage due to the moisture permeation caused by the step and the external impact was invented. This will be described below.

FIG. 2A is a plan view according to another embodiment of the present disclosure.

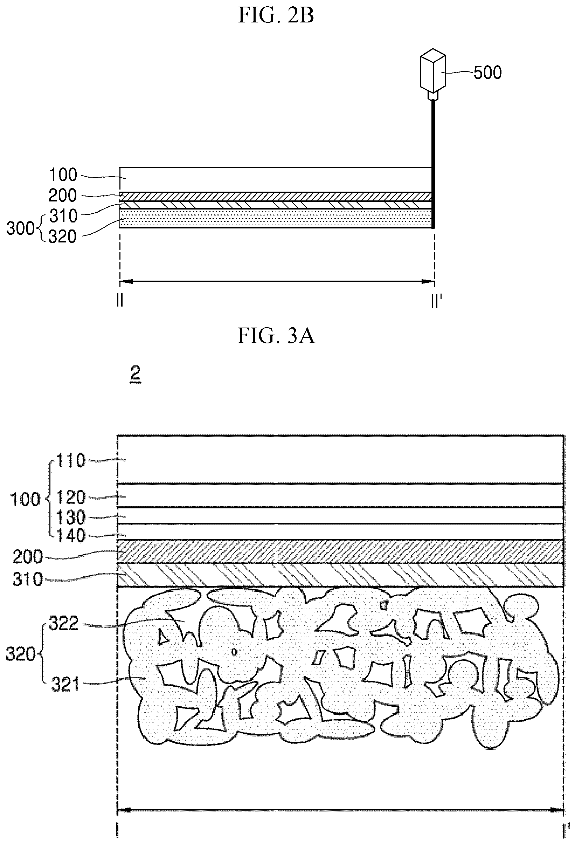

FIG. 2B is a cross-sectional view taken along a line II-II' in FIG. 2A.

Referring to FIG. 2A and 2B, a structure in which corresponding side surfaces of a display panel 100, a support member 200, and a cushion plate 300 are aligned with each other is shown. For example, this is a structure in which the step formed in the stacked structure of the display panel 100, the support member 200 and the cushion plate 300 is removed.

In order to remove a step of a display device 2, the cushion plate 300 is attached to the support member 200 located under the display panel 100 and then a portion of a distal end of the display device 2 is cut using a laser device 500. The method for removing the step of the display device 2 may not be limited thereto, and various methods may be applied.

In the display device 2 from which the portion of the distal end thereof is removed, corresponding distal ends of the display panel 100, the support member 200, and the cushion plate 300 may coincide with each other. For example, when the portions of the distal ends of the display panel 100, the support member 200, and the cushion plate 300 are cut together, the distal end of the display device 2 may have a straight shape without the step.

Because the display panel 100 includes the optical film, the encapsulation unit, the pixel array, and the display substrate, when the portion of the distal end of the display panel 100 is cut, corresponding distal ends of the optical film, the encapsulation unit, the display substrate, the support member 200, and the cushion plate 300 may all coincide with each other.

In order to remove the step of the display device 2, it is possible to cut the portions of the distal ends of the display panel 100 and the support member 200 except for the cushion plate 300. If the cushion plate 300 is not cut, the display panel 100 and the support member 200 may be aligned with each other to protrude more than the cushion plate 300 within a certain level.

That is, when only the display panel 100 and the support member 200 are cut with a laser at once to be processed such that the distal ends of the display panel 100 and the support member 200 coincide with each other without the step, it may be seen that the corresponding side surfaces of the display panel 100, the support member 200, and the cushion plate 300 are aligned with each other. It may be seen that the cushion plate 300 that is not cut with the laser is aligned with a difference in a level at which the side surface of the display panel 100 and the support member 200 may protrude within an error range of 5 um.

Even when the corresponding side surfaces of the display panel 100, the support member 200, and the cushion plate 300 are aligned with each other in the display device 2 as the display panel 100 protrudes more than the cushion plate 300 within, for example, a range of 5 *µ*m*,* the impact-absorption and moisture permeation prevention effects will occur similarly to the case in which the distal ends coincide with each other. The protruding length does not limit the content of the present disclosure. At least three side surfaces of the display panel 100, at least three side surfaces of the support member 200, and at least three side surfaces of the cushion plate 300 may coincide with each other or be aligned with each other in the display device 2, respectively. Because the circuit board 400 is connected to the bendable area formed in a lower portion of the display panel 100, it may be difficult to cut the display panel 100. Therefore, it is possible to make the distal ends to coincide with each other or to be aligned with each other by partially cutting at least one of an upper-side surface, a left-side surface, and a right-side surface except for a lower-side surface of the display device 2.

FIG. 3A is a cross-sectional view showing a display device according to an embodiment of the present disclosure.

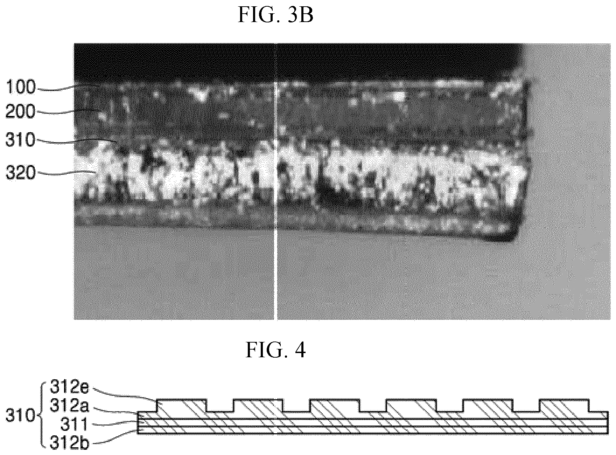

FIG. 3B is a figure obtained by applying FIG. 3A to a product. This is a product in which a step is removed by cutting a portion of a distal end of the product where the actual step is formed with the laser device 500. Detailed configuration and characteristics of the product are the same as those in FIG. 3A.

Referring to FIGs. 3A and 3B, the display panel 100 may include an optical film 110, an encapsulation unit 120, a pixel array 130, and a display substrate 140, and may have a structure in which the components are sequentially stacked.

The support member 200 may be disposed under the display panel 100 to support the display panel 100. The display panel 100 and the support member 200 may be attached to each other with an adhesive layer.

A porous substrate 320 may be disposed below the support member 200. The porous substrate 320, which is a metal structure 321 having a metal as a main component, may contain a plurality of pores 322 inside the metal structure 321. For example, the porous substrate 320 may be a porous metal structure having the plurality of pores 322 therein.

The porous substrate 320 may have the metal structure 321 as a main component and may dissipate the high-temperature heat generated from the display panel 100 or the driving integrated circuit 410, and may improve the heat-dissipation function by the pores 322 formed therein. Further, because the porous substrate 320 has a cushion function by the pores 322 inside the metal structure 321, the porous substrate 320 may effectively absorb the impact generated from the outside.

A porosity of the porous substrate 320 having the plurality of pores 322 may be in a range from 50 % to 76 %, and a size of each pore may be in a range from 20 *µ*m to 30 *µ*m. When the porosity is lower than the above range, a weight of the porous substrate 320 increases, and the heat-dissipation effect decreases as the pores become dense. Conversely, when the porosity exceeds the above range, there is a problem in that it is difficult to maintain a desired rigidity.

The porous substrate 320 may be formed in, for example, a following manufacturing method, but may not be limited thereto.

The porous substrate 320 may be formed by sintering a metal foam precursor containing a metal powder.

The metal foam precursor refers to a structure before proceeding with a process, such as the sintering, performed to form the porous substrate 320.

For example, the metal foam precursor may be formed using a slurry containing a metal powder, a dispersant, and a binder.

The metal powder may be a metal powder in which one or more metal powders among a copper powder, a nickel powder, an iron powder, a SUS(Steel Use Stainless) powder, a molybdenum powder, a silver powder, a platinum powder, a gold powder, an aluminum powder, a chromium powder, an indium powder, a tin powder, a magnesium powder, a phosphorus powder, a zinc powder, and a manganese powder are mixed, or a powder of an alloy of one or more metals, but may not be limited thereto.

The dispersant may be, for example, alcohol, but may not be limited thereto.

In this case, the alcohol may be monohydric alcohol having 1 to 20 carbon atoms, such as methanol, ethanol, propanol, pentanol, octanol, 2-methoxyethanol, 2-ethoxyethanol, 2-butoxyethanol, glycerol, texanol, or terpineol, dihydric alcohol having 1 to 20 carbon atoms, such as ethylene glycol, propylene glycol, hexanediol, octanediol, or pentanediol, or polyhydric alcohol, but may not be limited thereto.

A type of binder may not be particularly limited, and may be selected based on a type of the metal component or the dispersant used in preparing the slurry.

For example, the binder may use alkyl cellulose having an alkyl group having 1 to 8 carbon atoms, such as methyl cellulose or ethyl cellulose, polyalkylene carbonate having an alkylene unit having 1 to 8 carbon atoms, such as polypropylene carbonate or polyethylene carbonate, or a polyvinyl alcohol-based binder, such as polyvinyl alcohol or polyvinyl acetate, but may not be limited thereto.

After forming the slurry to contain the metal powder, the dispersant, and the binder as described above, the slurry may be injected into a mold having a predetermined shape or coated on a substrate to form the metal foam precursor.

The metal foam precursor thus formed may be formed into the porous substrate 320 through the sintering process.

The porous substrate 320 may be adhered to the support member 200 via an adhesive member 310.

The adhesive member 310 may contain an adhesive component, and may be in direct contact with the support member 200 to fix the porous substrate 320 to the support member 200.

FIG. 4 is a cross-sectional view of an adhesive member according to an embodiment of the present disclosure.

Referring to FIG. 4, the adhesive member 310 may include a base 311, a first adhesive layer 312a disposed on a first surface, which is a top face of the base 311, and a second adhesive layer 312b disposed on a second surface, which is a bottom surface of the base 311.

An embossed pattern 312e may be further included at a top of the first adhesive layer 312a, and the second adhesive layer 312b may be adhered to the porous substrate 320 to fix the porous substrate 320.

The first adhesive layer 312a and the second adhesive layer 312b may be made of or contain a material such as an optical clear adhesive (OCA), an optical clear resin (OCR), or a pressure sensitive adhesive (PSA).

When the first adhesive layer 312a has the embossed pattern 312e on the top face thereof, the embossed pattern 312e may be in contact with the support member 200 positioned on top of the adhesive member 310. Due to the embossed pattern 312e of the first adhesive layer 312a, it is possible to prevent air bubbles from being generated between the support member 200 and the adhesive member 310, so that a defoaming process for removing the air bubbles may be omitted.

The base 311 located in the middle of the adhesive member 310 may maintain shapes of the first adhesive layer 312a and the second adhesive layer 312b respectively disposed on both faces thereof and may be made of a material such as PET.

The embossed pattern 312e may have a thickness equal to or greater than 40 *µ*m in order to have an effective air bubble prevention effect, but the present disclosure may not be limited thereto.

A top face of the adhesive member 310 may be in contact with the support member 200, and a bottom surface thereof may be in contact with the porous substrate 320. For example, the first adhesive layer 312a and the embossed pattern 312e positioned at an upper portion of the adhesive member 310 may be adhered to the support member 200, and the second adhesive layer 312b positioned at a lower portion of the adhesive member 310 may be adhered to the porous substrate 320.

An adhesion target of the adhesive member 310 may not be limited thereto, and various components may be adhered depending on the product.

As a method for manufacturing the cushion plate 300 including the adhesive member 310 and the porous substrate 320, the cushion plate 300 may be formed by directly adhering the porous substrate 320 to the adhesive member 310, or by forming a metal foam precursor on the adhesive member 310 and sintering the metal foam precursor to form the porous substrate 320. The method for manufacturing the cushion plate 300 is not limited thereto.

The cushion plate 300 including the adhesive member 310 and the porous substrate 320 may have the heat-dissipation function and the cushion function at the same time by the plurality of pores 322 defined inside the porous substrate 320.

Because the porous substrate 320 is made of a metal with high thermal conductivity, the porous substrate 320 itself may provide an excellent heat-dissipation function, and may also provide an excellent cushion function because of the shape of the metal structure having the plurality of pores 322 therein.

Because the porous substrate 320 includes the metal structure having the plurality of pores 322 therein, an overall surface area thereof may be increased, so that the porous substrate 320 itself may provide the excellent heat-dissipation function.

Therefore, the cushion plate 300 according to one embodiment of the present disclosure may have the effective heat-dissipation function and cushion function at the same time with only the porous substrate 320 without a need to add a heat-dissipation layer for the heat-dissipation function and a cushion layer for the cushion function as separate layers.

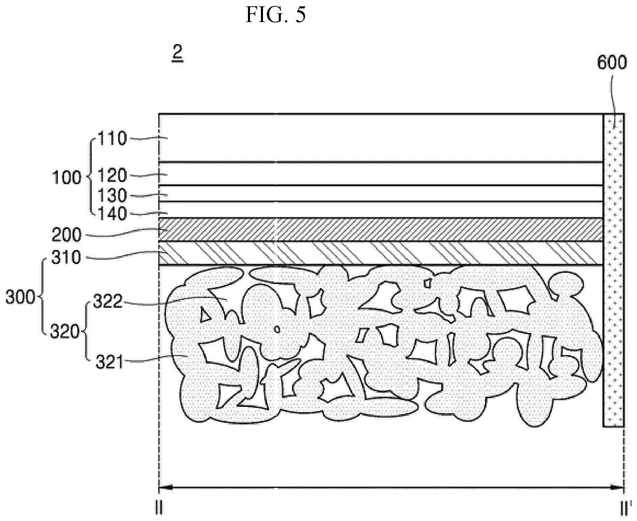

FIG. 5 is a cross-sectional view showing an embodiment of the present disclosure in which a resin is applied onto a display device.

Referring to FIG. 5, a crack or a micro breakage may occur on the side surface of the display device 2 from which the step is removed. The crack or the micro breakage occurring on the side surface of the display panel 100 may progress throughout the display panel 100 by the external impact, thereby reducing reliability of the display device 2.

Further, when the distal ends of the display panel 100, the support member 200, and the cushion plate 300 are cut together, an adhesion between the display panel 100, the support member 200, and the cushion plate 300 may be weakened or the separation of the layers may occur, so that the external moisture or the foreign substances may easily penetrate into the device.

Therefore, in order to prevent the damage that occurs and progresses from the side surface of the display panel 100 or to prevent the moisture penetration that proceeds from the side surface of the display device 2, a resin 600 may be applied to the entire side surfaces of the display panel 100, the support member 200, and the cushion plate 300.

The resin 600 may include a thermosetting resin, an ultraviolet (UV) curable resin, or the like, and may have characteristics such as being waterproof, rigidity improvement, and static dissipation.

For example, the static dissipation characteristics of the resin 600 may be realized by adding a conductive material or the like to the thermosetting resin or the ultraviolet (UV) curable resin. The conductive material may be a silver (Ag) paste, but may not be limited thereto.

The resin 600 may be applied to the upper-side surface, the left-side surface, and the right-side surface of the display device 2 including the display panel 100, the support member 200, and the cushion plate 300.

The rigidity and the adhesion may be weakened on the upper-side surface, the left-side surface, and the right-side surface of the display device 2 by the cutting, and the rigidity and the adhesion may be supplemented by the application of the resin 600,

Further, it is possible to effectively prevent moisture from penetrating into the display panel 100 and the pores 322 of the porous substrate 320.

When the resin 600 is applied to the display device 2, because the size of the non-display area of the display device 2 increases based on the thickness of the resin 600, there may be a disadvantage in terms of design.

Therefore, the resin 600 may be applied with a minimum thickness to have sufficient waterproof and impact-absorption effects. For example, the resin 600 may be applied to have a thickness in a range from 100 to 200 *µ*m. Therefore, the resin 600 may have the sufficient waterproof and impact-absorption effects, which may be advantageous in terms of the design.

The lower-side surface of the display device 2 is a portion that is not cut. In order to mount the circuit board 400 or the driving integrated circuit 410, the non-display area may be formed on the lower-side surface of the display device 2 with a relatively large area. Therefore, the crack, the micro breakage, and the moisture penetration may less occur on the lower-side surface of the display device 2 than in other area. Even when the crack, the micro breakage, and the moisture penetration occur, a possibility of progress to the display area may be lower on the lower-side surface than in other areas. Therefore, the resin application may be omitted on the lower-side surface of the display device 2.

The resin 600 may be applied to the side surfaces of the optical film 110, the encapsulation unit 120, and the display substrate 140 constituting the display panel 100 to solve the problems of the weakening of the adhesion and the moisture penetration occurring in the stack structure of the display panel 100.

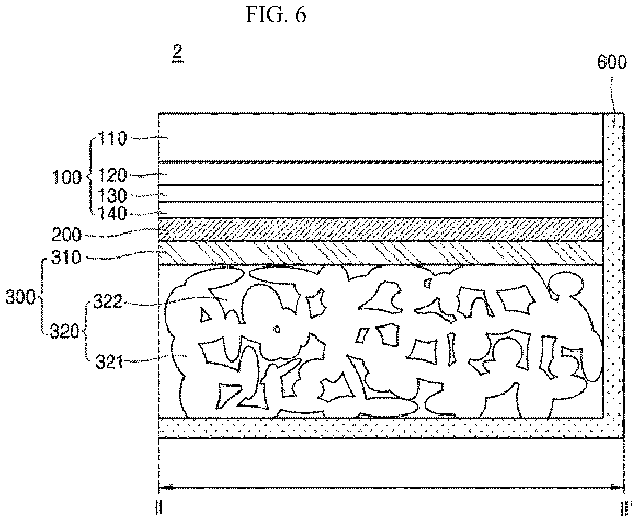

FIG. 6 is a view showing another embodiment of the present disclosure in which a resin is applied onto a display device.

Referring to FIG. 6, the porous substrate 320 may have the pores 322 as a whole. Because a bottom surface of the porous substrate 320 also has the pores 322, the moisture may penetrate through the bottom surface of the porous substrate 320. Further, because irregularities are also formed on the bottom surface of the porous substrate 320, when the irregularities are recognized from the outside, the display quality of the display device 2 may be reduced.

Therefore, by additionally placing the resin 600 on a back surface of the cushion plate 300, it is possible to effectively prevent moisture from penetrating through a bottom surface of the cushion plate 300, and it is possible to improve the display quality of the display device 2 by flattening the bottom irregularities of the cushion plate 300.

The display device according to an embodiment of the present disclosure may be described as follows.

An aspect of the present disclosure provides a display device including: a display panel for displaying an image; a support member disposed under the display panel; and a cushion plate disposed under the support member and including a porous substrate, wherein corresponding side surfaces of the display panel, the support member, and the cushion plate are aligned with each other.

In one implementation, the display panel includes an optical film, an encapsulation unit, a pixel array, and a display substrate, and corresponding side surfaces of the optical film, the encapsulation unit, the display substrate, the support member, and the cushion plate are aligned with each other.

In one implementation, at least three side surfaces of the display panel, at least three side surfaces of the support member, and at least three side surfaces of the cushion plate are aligned with each other, respectively.

In one implementation, an upper-side surface, a left-side surface, and a right-side surface of the display panel, an upper-side surface, a left-side surface, and a right-side surface of the support member, and an upper-side surface, a left-side surface, and a right-side surface of the cushion plate are aligned with each other, respectively.

In one implementation, corresponding distal ends of the display panel, the support member, and the cushion plate coincide with each other in a partial area of the display device.

In one implementation, an upper-distal end, a left-distal end, and a right-distal end of the display panel, an upper-distal end, a left-distal end, and a right-distal end of the support member, and an upper-distal end, a left-distal end, and a right-distal end of the cushion plate are aligned with each other, respectively.

In one implementation, the porous substrate contains a conductive metal and a plurality of pores located inside the conductive metal, and the porous substrate has a porosity in a range from 50 % to 76 %.

In one implementation, the cushion plate further includes an adhesive member, the adhesive member includes a base, a first adhesive layer disposed on a first surface of the base, and a second adhesive layer disposed on a second surface of the base opposite to the first surface of the base, and the first adhesive layer has an embossed pattern adhered to the support member and the second adhesive layer is adhered to the porous substrate.

In one implementation, the cushion plate further includes a protrusion, and the protrusion is disposed between the porous substrate and the support member to be in contact with the porous substrate.

In one implementation, the protrusion includes a flat portion located at an upper portion and a fine protrusion located on a back surface of the flat portion, and the fine protrusion is placed in an uneven portion formed on a top face of the porous substrate.

In one implementation, the fine protrusion has a size in a range from 3 to 5 *µ*m, and has a circular, square, or rectangular shape.

In one implementation, the display device further includes an embossed pattern located on top of the flat portion of the protrusion.

In one implementation, the display device further includes a resin disposed on the side surfaces of the display panel, the support member, and the cushion plate.

In one implementation, the resin is further disposed on a back surface of the cushion plate.

In one implementation, the resin includes a thermosetting resin or a UV curable resin.

In one implementation, the resin has one or more characteristics of waterproof, rigidity, and static dissipation.

In one implementation, the resin is disposed on respective upper-side surface, left-side surface, and right-side surface of the display panel, the support member, and the cushion plate.

In another embodiment, a display device comprises a display panel for displaying an image, a cushion plate disposed under the display panel and including a porous substrate, and a resin disposed on one or more surfaces of the display panel and the cushion plate. The corresponding side surfaces of the display panel and the cushion plate are aligned with each other, and the resin is disposed on the corresponding side surfaces of the display panel and the cushion plate.

A scope of protection of the present disclosure should be construed by the scope of the claims, and all technical ideas within the scope equivalent thereto should be construed as being included in the scope of the present disclosure. Although the embodiments of the present disclosure have been described in more detail with reference to the accompanying drawings, the present disclosure is not necessarily limited to these embodiments. The present disclosure may be implemented in various modified manners within the scope not departing from the technical idea of the present disclosure. Accordingly, the embodiments disclosed in the present disclosure are not intended to limit the technical idea of the present disclosure, but to describe the present disclosure. The scope of protection of the present disclosure should be interpreted by the claims.

## Claims

1. A display device (1) comprising:
a display panel (10, 100) for displaying an image;
a support member (20, 200) disposed under the display panel (10, 100); and
a cushion plate (30, 300) disposed under the support member (20, 200) and including a porous substrate; and
a resin (600) disposed on the side surfaces of the display panel (10, 100), the support member (20, 200), and the cushion plate (30, 300);
wherein corresponding side surfaces of the display panel (10, 100), the support member (20, 200), and the cushion plate (30, 300) are aligned with each other.

2. The display device (1) of claim 1, wherein the display panel (10, 100) includes an optical film (110), an encapsulation unit (120), a pixel array (130), and a display substrate (140), and
wherein corresponding side surfaces of the optical film (110), the encapsulation unit (120), the display substrate (140), the support member (20, 200), and the cushion plate (30, 300) are aligned with each other.

3. The display device (1) of claim 1, wherein at least three side surfaces of the display panel (10, 100), at least three side surfaces of the support member (20, 200), and at least three side surfaces of the cushion plate (30, 300) are aligned with each other, respectively.

4. The display device (1) of claim 3, wherein an upper-side surface, a left-side surface, and a right-side surface of the display panel (10, 100), an upper-side surface, a left-side surface, and a right-side surface of the support member (20, 200), and an upper-side surface, a left-side surface, and a right-side surface of the cushion plate (30, 300) are aligned with each other, respectively.

5. The display device (1) of claim 1, wherein corresponding distal ends of the display panel (10, 100), the support member (20, 200), and the cushion plate (30, 300) coincide with each other in at least a part of the display device (1).

6. The display device (1) of claim 5, wherein an upper-distal end, a left-distal end, and a right-distal end of the display panel (10, 100), an upper-distal end, a left-distal end, and a right-distal end of the support member (20, 200), and an upper-distal end, a left-distal end, and a right-distal end of the cushion plate (30, 300) are aligned with each other, respectively.

7. The display device (1) of claim 1, wherein the porous substrate contains a conductive metal and a plurality of pores located inside the conductive metal, and
wherein the porous substrate has a porosity in a range from 50 % to 76 %.

8. The display device (1) of claim 1, wherein the cushion plate (30, 300) further includes an adhesive member (31, 310),
wherein the adhesive member (31, 310) includes a base (311), a first adhesive layer (312a) disposed on a first surface of the base (311), and a second adhesive layer (312b) disposed on a second surface of the base (311) opposite to the first surface of the base (311), and
wherein the first adhesive layer (312a) has an embossed pattern adhered to the support member (20, 200) and the second adhesive layer (312b) is adhered to the porous substrate.

9. The display device (1) of claim 1, wherein the resin (600) is further disposed on a back surface of the cushion plate (30, 300).

10. The display device (1) of claim 1, wherein the resin (600) includes a thermosetting resin or a UV curable resin.

11. The display device (1) of claim 1, wherein the resin (600) has one or more characteristics of waterproof, rigidity, and static dissipation.

12. The display device (1) of claim 1, wherein the resin (600) is disposed on respective upper-side surface, left-side surface, and right-side surface of the display panel (10, 100), the support member (20, 200), and the cushion plate (30, 300).

13. The display device (1) of claim 7, wherein the conductive metal of the porous substrate includes copper (Cu).

## Patentansprüche

1. Anzeigevorrichtung (1), aufweisend:
ein Anzeigepanel (10, 100) zum Anzeigen eines Bildes,
ein Stützelement (20, 200), das unter dem Anzeigepanel (10, 100) angeordnet ist, und
eine Polsterplatte (30, 300), die unter dem Stützelement (20, 200) angeordnet ist und ein poröses Substrat aufweist, und
ein Harz (600), das auf den Seitenflächen des Anzeigepanels (10, 100), des Stützelements (20, 200) und der Polsterplatte (30, 300) angeordnet ist,
wobei korrespondierende Seitenflächen des Anzeigepanels (10, 100), des Stützelements (20, 200) und der Polsterplatte (30, 300) zueinander ausgerichtet sind.

2. Anzeigevorrichtung (1) gemäß Anspruch 1, wobei das Anzeigepanel (10, 100) einen optischen Film (110), eine Verkapselungseinheit (120), ein Pixelarray (130) und ein Anzeigesubstrat (140) aufweist, und
wobei korrespondierende Seitenflächen des optischen Films (110), der Verkapselungseinheit (120), des Anzeigesubstrats (140), des Stützelements (20, 200) und der Polsterplatte (30, 300) zueinander ausgerichtet sind.

3. Anzeigevorrichtung (1) gemäß Anspruch 1, wobei mindestens drei Seitenflächen des Anzeigepanels (10, 100), mindestens drei Seitenflächen des Stützelements (20, 200) und mindestens drei Seitenflächen der Polsterplatte (30, 300) jeweils zueinander ausgerichtet sind.

4. Anzeigevorrichtung (1) gemäß Anspruch 3, wobei eine obere Seitenfläche, eine linke Seitenfläche und eine rechte Seitenfläche des Anzeigepanels (10, 100), eine obere Seitenfläche, eine linke Seitenfläche und eine rechte Seitenfläche des Stützelements (20, 200) und eine obere Seitenfläche, eine linke Seitenfläche und eine rechte Seitenfläche der Polsterplatte (30, 300) jeweils zueinander ausgerichtet sind.

5. Anzeigevorrichtung (1) gemäß Anspruch 1, wobei korrespondierende distale Enden des Anzeigepanels (10, 100), des Stützelements (20, 200) und der Polsterplatte (30, 300) in mindestens einem Teil der Anzeigevorrichtung (1) miteinander übereinstimmen.

6. Anzeigevorrichtung (1) gemäß Anspruch 5, wobei ein oberes distales Ende, ein linkes distales Ende und ein rechtes distales Ende des Anzeigepanels (10, 100), ein oberes distales Ende, ein linkes distales Ende und ein rechtes distales Ende des Stützelements (20, 200) und ein oberes distales Ende, ein linkes distales Ende und ein rechtes distales Ende der Polsterplatte (30, 300) jeweils zueinander ausgerichtet sind.

7. Anzeigevorrichtung (1) gemäß Anspruch 1, wobei das poröse Substrat ein leitfähiges Metall und eine Mehrzahl von Poren enthält, die sich innerhalb des leitfähigen Metalls befinden, und
wobei das poröse Substrat eine Porosität in einem Bereich von 50 % bis 76 % hat.

8. Anzeigevorrichtung (1) gemäß Anspruch 1, wobei die Polsterplatte (30, 300) ferner ein Klebeelement (31, 310) aufweist,
wobei das Klebeelement (31, 310) eine Basis (311), eine erste Klebeschicht (312a), die auf einer ersten Fläche der Basis (311) angeordnet ist, und eine zweite Klebeschicht (312b), die auf einer zweiten Fläche der Basis (311) gegenüber der ersten Fläche der Basis (311) angeordnet ist, aufweist, und
wobei die erste Klebeschicht (312a) ein Prägemuster hat, das an dem Stützelement (20, 200) haftet, und die zweite Klebeschicht (312b) an dem porösen Substrat haftet.

9. Anzeigevorrichtung (1) gemäß Anspruch 1, wobei das Harz (600) ferner auf einer Rückfläche der Polsterplatte (30, 300) angeordnet ist.

10. Anzeigevorrichtung (1) gemäß Anspruch 1, wobei das Harz (600) ein wärmehärtbares Harz oder ein UV-härtbares Harz aufweist.

11. Anzeigevorrichtung (1) gemäß Anspruch 1, wobei das Harz (600) eine oder mehrere Eigenschaften von Wasserdichtigkeit, Steifigkeit und statischer Ableitung hat.

12. Anzeigevorrichtung (1) gemäß Anspruch 1, wobei das Harz (600) auf einer jeweiligen oberen Seitenfläche, linken Seitenfläche und rechten Seitenfläche des Anzeigepanels (10, 100), des Stützelements (20, 200) und der Polsterplatte (30, 300) angeordnet ist.

13. Anzeigevorrichtung (1) gemäß Anspruch 7, wobei das leitfähige Metall des porösen Substrats Kupfer (Cu) aufweist.

## Revendications

1. Dispositif d'affichage (1), comprenant :
un panneau d'affichage (10, 100) pour afficher une image ;
un élément de support (20, 200) disposé sous le panneau d'affichage (10, 100) ; et
une plaque de rembourrage (30, 300) disposée sous l'élément de support (20, 200) et comprenant un substrat poreux ; et
une résine (600) disposée sur les surfaces latérales du panneau d'affichage (10, 100), de l'élément de support (20, 200) et de la plaque de rembourrage (30, 300) ;
dans lequel des surfaces latérales correspondantes du panneau d'affichage (10, 100), de l'élément de support (20, 200) et de la plaque de rembourrage (30, 300) sont alignées les unes avec les autres.

2. Dispositif d'affichage (1) selon la revendication 1, dans lequel le panneau d'affichage (10, 100) comprend un film optique (110), une unité d'encapsulation (120), un réseau de pixels (130) et un substrat d'affichage (140), et
dans lequel des surfaces latérales correspondantes du film optique (110), de l'unité d'encapsulation (120), du substrat d'affichage (140), de l'élément de support (20, 200) et de la plaque de rembourrage (30, 300) sont alignées les unes avec les autres.

3. Dispositif d'affichage (1) selon la revendication 1, dans lequel au moins trois surfaces latérales du panneau d'affichage (10, 100), au moins trois surfaces latérales de l'élément de support (20, 200) et au moins trois surfaces latérales de la plaque de rembourrage (30, 300) sont alignées les unes avec les autres, respectivement.

4. Dispositif d'affichage (1) selon la revendication 3, dans lequel une surface latérale supérieure, une surface latérale gauche et une surface latérale droite du panneau d'affichage (10, 100), une surface latérale supérieure, une surface latérale gauche et une surface latérale droite de l'élément de support (20, 200), et une surface latérale supérieure, une surface latérale gauche et une surface latérale droite de la plaque de rembourrage (30, 300) sont alignées les unes avec les autres, respectivement.

5. Dispositif d'affichage (1) selon la revendication 1, dans lequel des extrémités distales correspondantes du panneau d'affichage (10, 100), de l'élément de support (20, 200) et de la plaque de rembourrage (30, 300) coïncident les unes avec les autres dans au moins une partie du dispositif d'affichage (1).

6. Dispositif d'affichage (1) selon la revendication 5, dans lequel une extrémité distale supérieure, une extrémité distale gauche et une extrémité distale droite du panneau d'affichage (10, 100), une extrémité distale supérieure, une extrémité distale gauche et une extrémité distale droite de l'élément de support (20, 200), et une extrémité distale supérieure, une extrémité distale gauche et une extrémité distale droite de la plaque de rembourrage (30, 300) sont alignées les unes avec les autres, respectivement.

7. Dispositif d'affichage (1) selon la revendication 1, dans lequel le substrat poreux contient un métal conducteur et une pluralité de pores situés à l'intérieur du métal conducteur, et
dans lequel le substrat poreux a une porosité comprise dans une plage de 50 % à 76 %.

8. Dispositif d'affichage (1) selon la revendication 1, dans lequel la plaque de rembourrage (30, 300) comprend en outre un élément adhésif (31, 310),
dans lequel l'élément adhésif (31, 310) comprend une base (311), une première couche adhésive (312a) disposée sur une première surface de la base (311), et une deuxième couche adhésive (312b) disposée sur une deuxième surface de la base (311) opposée à la première surface de la base (311), et
dans lequel la première couche adhésive (312a) présente un motif gaufré collé à l'élément de support (20, 200) et la deuxième couche adhésive (312b) est collée au substrat poreux.

9. Dispositif d'affichage (1) selon la revendication 1, dans lequel la résine (600) est en outre disposée sur une surface arrière de la plaque de rembourrage (30, 300).

10. Dispositif d'affichage (1) selon la revendication 1, dans lequel la résine (600) comprend une résine thermodurcissable ou une résine durcissable aux UV.

11. Dispositif d'affichage (1) selon la revendication 1, dans lequel la résine (600) présente une ou plusieurs caractéristiques parmi l'étanchéité, la rigidité et la dissipation statique.

12. Dispositif d'affichage (1) selon la revendication 1, dans lequel la résine (600) est disposée sur une surface latérale supérieure, une surface latérale gauche et une surface latérale droite respectives du panneau d'affichage (10, 100), de l'élément de support (20, 200) et de la plaque de rembourrage (30, 300).

13. Dispositif d'affichage (1) selon la revendication 7, dans lequel le métal conducteur du substrat poreux comprend du cuivre (Cu).
